# EUROPÄISCHE PATENTANMELDUNG

(11) **EP 2 852 266 A2**
(43) Veröffentlichungstag der Anmeldung: **25.03.2015**
(21) Anmeldenummer: 14185905.8
(22) Anmeldetag: 23.09.2014
(51) Int. Cl.: H05K 7/14, H02G 3/08

(54) **Kabelgehäuse zur Montage an einem Industriesteckverbinder und Anordnung**

(30) Priorität: 23.09.2013 DE 202013104340 U
(71) Anmelder: Beelenherm, Horst, 31708 Ahnsen (DE)
(72) Erfinder: Beelenherm, Horst, 31708 Ahnsen (DE)
(74) Vertreter: Bittner, Thomas L.

(57) **Zusammenfassung**

Die Erfindung betrifft ein Kabelgehäuse zur Montage an einem Industriesteckverbinder, mit einem einen Innenraum umschließenden Rahmen, wobei der Innenraum ein oder mehrere aus dem Industriesteckverbinder herausragende Kabel aufnimmt, wobei der Rahmen eine Vorderwand (1) aufweist, die von dem Rahmen lösbar ist, derart, dass ein Zugriff zu dem Innenraum ermöglicht ist, und wobei auf einer dem Industriesteckverbinder zugewandten Seite des Rahmens ein Befestigungselement (6) zum Befestigen des Rahmens an dem Industriesteckverbinder gebildet ist. Des Weiteren betrifft die Erfindung eine Anordnung umfassend einen Industriesteckverbinder und ein hieran montiertes Kabelgehäuse.

## Beschreibung

Die Erfindung betrifft ein Kabelgehäuse zur Montage an einem Industriesteckverbinder und eine Anordnung.

### Hintergrund

Bei Industriesteckverbindern ist die Montage und Wartung schwierig, wenn diese an geschlossene Kabelschächte angeschlossen sind. In diesem Fall hat ein Nutzer praktisch keinen Platz, um zu arbeiten. An den Industriesteckverbinder angeschlossene Kabel können nicht zurückgezogen werden, um einen Zugriff auf die inneren Komponenten des Verbinders zu ermöglichen. Die Kabel müssen daher unter dem Verbinder untergebracht werden.

Im Formenbau und im Anlagenbau werden in der Regel sehr starke und biegesteife Kabel (z.B. zur Stromversorgung) zusammen mit sehr dünnen Kabeln (z.B. zum Übertragen von Steuersignalen) eingesetzt. Bei der Montage bzw. Wartung kommt es häufig zu Beschädigungen an den Kabeln. Nach einer Wartung ist es oftmals schwierig, den Steckverbinder wieder vollständig zu montieren. Infolgedessen bleiben einige Kabel ungeschützt hängen, was zu gefährlichen Zuständen führt.

Es soll eine Möglichkeit geschaffen werden, die Montage und Wartung der Industriesteckverbinder zu vereinfachen.

In dem Dokument DE 296 06 194 U1 ist ein Anschlussgehäuse in einer Mehrkammerbauart beschrieben. Ziel ist es, Elektronik und Anschlusstechnik zu trennen. Hierzu ist eine Elektronikleiterplatte vorgesehen, die in das Gehäuse eingeschoben werden kann. Die oben genannten Probleme werden hierdurch jedoch nicht gelöst.

### Zusammenfassung

Aufgabe ist es, verbesserte Technologien zum Montieren und Warten von Industriesteckverbindern anzugeben. Insbesondere soll eine Montage und Wartung der Industriesteckverbinder vereinfacht werden.

Die Aufgabe wird durch das Kabelgehäuse nach dem unabhängigen Anspruch 1 sowie die Anordnung nach dem unabhängigen Anspruch 10 gelöst. Vorteilhafte Ausführungsformen sind Gegenstand von abhängigen Ansprüchen.

Nach einem Aspekt ist ein Kabelgehäuse zur Montage an einem Industriesteckverbinder vorgesehen. Ein Rahmen des Kabelgehäuses umschließt einen Innenraum, wobei der Innenraum ein oder mehrere aus dem Industriesteckverbinder herausragende Kabel aufnimmt. Die aus dem Industriesteckverbinder herausragenden Kabel können in einem Kabelbaum zusammengefasst sein. Der Rahmen weist eine Vorderwand auf, die von dem Rahmen lösbar ist, derart, dass ein Zugriff zu dem Innenraum ermöglicht ist. Auf einer dem Industriesteckverbinder zugewandten Seite des Rahmens ist ein Befestigungselement zum Befestigen des Rahmens an dem Industriesteckverbinder gebildet.

Nach einem weiteren Aspekt ist eine Anordnung umfassend einen Industriesteckverbinder und ein hieran montiertes Kabelgehäuse bereitgestellt.

Das Kabelgehäuse ist insbesondere für eine Montage an einem Industrie-Kraft/Signalsteckverbinder vorgesehen. Derartige Steckverbinder sind auch unter der Bezeichnung Han-Steckverbinder bekannt. Der Han-Steckverbinder wurde von der Fa. Harting entwickelt und hat sich zum Standard für Industrie-Kraft/Signalsteckverbinder durchgesetzt. Die Bezeichnung Han-Steckverbinder wurde auch als eine Marke des Jahrhunderts ausgezeichnet, was die umfängliche Verwendung dieses Begriffs noch unterstreicht.

Der Industrie-Kraft/Signalsteckverbinder weist mehrere Komponenten auf. Er umfasst eine Kabelverschraubung, die an einem Gehäuseoberteil angeordnet ist. Das Gehäuseoberteil nimmt einen Stifteinsatz auf. Der Stifteinsatz kann einen oder mehrere Kontaktstifte aufnehmen. In einem Gehäuseunterteil ist ein Buchseneinsatz angeordnet, der eine oder mehrere Kontaktbuchsen aufnimmt. Das Gehäuseunterteil kann in verschiedenen Ausführungsformen bereitgestellt werden, nämlich als Anbaugehäuse, als Sockelgehäuse und als Kupplungsgehäuse. Das Gehäuseunterteil kann mit oder ohne eine Abdeckkappe gebildet sein. Es kann eine niedrige oder hohe Bauform aufweisen und aus Kunststoff oder Metall bestehen. Das Gehäuseunterteil kann des Weiteren einen oder zwei Verriegelungsbügel zur Befestigung an dem Gehäuseoberteil aufweisen. Der Stifteinsatz und / oder der Buchseneinsatz können einen der folgenden Anschlüsse aufweisen: Schraubanschluss, Crimpanschluss und Käfigzugfederanschluss.

Der Stifteinsatz und der Buchseneinsatz weisen in der Regel eine gleiche Anzahl von Kontaktstiften bzw. Kontaktbuchsen auf Die Anzahl wird auch als Polarität bezeichnet. Der Industriesteckverbinder kann beispielsweise 4-polig, 6-polig, 7-polig, 8-polig, 10-polig, 12-polig, 16-polig, 18-polig, 20-polig, 24-polig, 32-polig, 40-polig, 42-polig, 46-polig, 64-polig, 72-polig und 108-polig ausgeführt sein.

Das Kabelgehäuse ist besonders zur Montage an dem Gehäuseunterteil geeignet. Es kann auch vorgesehen sein, dass an dem Gehäuseunterteil ein Aufbaurahmen montiert ist, an dem das Kabelgehäuse befestigt ist. Die Größe des Kabelgehäuses kann an die Größe des Industriesteckverbinders angepasst werden, insbesondere an die Größe des Gehäuseunterteils oder des Aufbaurahmens.

Zur Verkabelung eines Industriesteckverbinders wird das Kabelgehäuse zwischen einem Steckergehäuse und einem Anlageobjekt (z.B. Spritzform, Industriescanner oder Tiefziehanlage) angeordnet. Die Vorderwand wird von dem Rahmen gelöst, sodass ein Nutzer Zugriff auf den Innenraum hat. Der Stifteinsatz bzw. der Buchseneinsatz mit den hieran angeschlossenen Kabeln wird von oben in das Steckergehäuse geschoben und hieran befestigt. Während des Einschiebens können die Kabel durch die von der abgenommenen Vorderwand gebildeten Öffnung herausgezogen werden. Auf diese Weise wird verhindert, dass die Kabel geknickt oder abgerissen werden. Nach der Befestigung des Stifteinsatzes bzw. Buchseneinsatzes an dem Industriesteckverbinder, beispielsweise mittels Verschrauben, werden die Kabel in das Kabelgehäuse eingeschoben. Zum Abschluss wird die Vorderwand an dem Rahmen befestigt, sodass das Kabelgehäuse geschlossen ist. Für eine Überprüfung der Polung des Industriesteckverbinders kann die Vorderwand von dem Rahmen gelöst werden, sodass der Nutzer einfach an die Kabel herankommt.

Es kann vorgesehen sein, dass der Rahmen eine erste Seitenwand, eine zweite Seitenwand und eine Rückwand aufweist. Zusammen mit der Vorderwand umfasst der Rahmen somit vier Komponenten. Dies ermöglicht eine flexible Anpassung der Größe und Geometrie des Rahmens an die Abmessungen des Industriesteckverbinders, an welchen er montiert werden soll. Beispielsweise kann in einer dem Industriesteckverbinder zugewandten Seite der ersten Seitenwand und / oder der zweiten Seitenwand eine oder mehrere Bohrungen gebildet sein. Hierdurch ist es ermöglicht, den Rahmen mittels geeigneter Schrauben an dem Industriesteckverbinder lösbar zu befestigen. Bevorzugt weisen beide Seitenwände jeweils zwei Bohrungen auf. Die vier Komponenten des Rahmens können im montierten Zustand ineinander gesteckt sein, um das Kabelgehäuse zu bilden.

Es kann beispielsweise vorgesehen sein, dass die Vorderwand zwischen der ersten und zweiten Seitenwand eingeklemmt ist. Auf zwei gegenüberliegenden Seiten der Vorderwand kann jeweils ein Vorsprung gebildet sein, der in eine in der ersten und zweiten Seitenwand jeweils gebildete vordere Aufnahme eingreift. Zum Herausnehmen bzw. Einsetzen der Vorderwand werden die beiden Seitenwände leicht aufgebogen.

Nach einer Ausführungsform ist vorgesehen, dass an zwei gegenüberüberliegenden Seiten der Rückwand jeweils ein Vorsprung mit einem auf dem Vorsprung angeordneten Halteelement gebildet ist, wobei der Vorsprung mit dem Halteelement in eine in der ersten und zweiten Seitenwand jeweils gebildeten hintere Aufnahme eingreift. Zur Montage werden die beiden Seitenwände auf die Vorsprünge mit den Halteelementen geschoben. Die ermöglicht einen sicheren Halt der beiden Seitenwände. Beispielsweise kann das Halteelement im Wesentlichen mittig auf dem Vorsprung angeordnet sein. Die hintere Aufnahme kann jeweils als vollständiger Durchbruch in der ersten bzw. zweiten Seitenwand gebildet sein.

Ergänzend kann vorgesehen sein, dass in der jeweiligen hinteren Aufnahme der ersten und zweiten Seitenwand ein Kugelvorsprung gebildet ist und auf dem Halteelement eine Kugelaufnahme gebildet ist, sodass der Kugelvorsprung und die Kugelaufnahme im montierten Zustand miteinander in Eingriff stehen. Die Kugelaufnahme kann auf einer dem Innenraum abgewandten Seite des Halteelements gebildet sein. Die hiermit verwirklichte Kugelverrastung verbessert die Befestigung der Seitenwände an der Rückwand. Darüber hinaus führt die Kugelverrastung dazu, dass die beiden Seitenwände nach einem Verbiegen, beispielsweise zum Entfernen der Vorderwand, automatisch in einen Ausgangszustand zurückgeführt werden. Der Kugelvorsprung kann beispielsweise zentriert auf dem Halteelement angeordnet sein.

Eine Weiterbildung sieht vor, dass der Vorsprung auf einer dem Innenraum abgewandten Seite jeweils zumindest abschnittsweise mit einer abgeschrägten Kante gebildet ist. Die Schräge erleichtert ein Aufbiegen der beiden Seitenwände zum Entfernen bzw. Einsetzen der Vorderwand. Die Schräge kann mit einer parallel zur Rückwand gedachten Ebene einen Winkel von 5° einschließen. Bevorzugt ist die abgeschrägte Kante entlang des Vorsprungs oberhalb und unterhalb des Halteelements gebildet.

Gemäß einer anderen Ausführungsform ist vorgesehen, dass an der Vorderwand ein Griffelement gebildet ist. Das Griffelement erleichtert das Einsetzen bzw. Entfernen der Vorderwand. Das Griffelement kann zentriert auf der Vorderwand angeordnet sein. Es kann eine Mulde in der Vorderwand gebildet sein, in welcher das Griffelement angeordnet ist.

Es kann vorgesehen sein, dass der Rahmen ein Kunststoffmaterial oder ein Zinkdruckgussmaterial enthält. Die Komponenten des Rahmens können auch vollständig aus einem Kunststoffmaterial oder einem Zinkdruckgussmaterial bestehen. Die Komponenten (Vorderwand, Rückwand sowie erste und zweite Seitenwand) können jeweils auf einer dem Innenraum zugewandten Seite Verstärkungsverstrebungen aufweisen, um Material zu sparen. Beispielsweise können die Komponenten mittels eines Spritzgussverfahren aus Kunststoff hergestellt werden. Des Weiteren können auf einer dem Innenraum abgewandten Seite der beiden Seitenteile Ausnehmungen gebildet sein. Alternativ können einzelne oder alle Komponenten aus einem Vollmaterial bestehen. Die Komponenten können aus dem gleichen oder aus verschiedenen Materialien bestehen.

Nach einer weiteren Ausführungsform ist vorgesehen, dass an einer dem Industriesteckverbinder abgewandten Seite des Rahmens Wärmeableitelemente gebildet sind. Bevorzugt sind die Wärmeableitelemente auf einer dem Industriesteckverbinder abgewandten Seite der Vorderwand und / oder der Rückwand gebildet. Die Wärmeableitelemente können als Ausnehmungen im Material der Komponenten gebildet sein, sodass warme Luft durch die Ausnehmungen aus dem Innenraum austreten kann. Die Ausnehmungen können gleichmäßig über die Länge der Komponenten verteilt gebildet sein.

### Beschreibung einzelner Ausführungsformen

Im Folgenden wird eine Ausführungsform unter Bezugnahme auf Figuren einer Zeichnung erläutert. Hierbei zeigen:
- Fig. 1: eine schematische Darstellung eines Kabelgehäuses,
- Fig. 2: eine schematische Darstellung mehrerer Ansichten einer Vorderwand,
- Fig. 3: eine schematische Darstellung mehrerer Ansichten einer Rückwand und
- Fig. 4: eine schematische Darstellung mehrerer Ansichten einer Seitenwand.

Im Folgenden werden für gleiche Elemente gleiche Bezugszeichen verwendet.

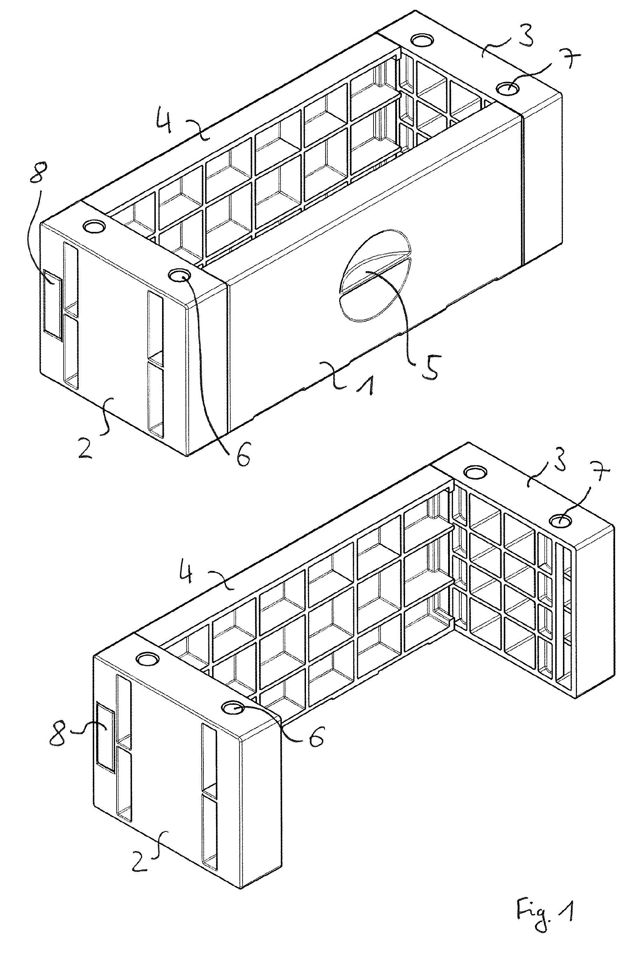

Fig. 1 zeigt eine schematische Darstellung eines Rahmens des Kabelgehäuses. Im oberen Abschnitt von Fig. 1 ist der Rahmen mit den Komponenten Vorderwand 1, erste Seitenwand 2, zweite Seitenwand 3 und Rückwand 4 dargestellt. Die vier Komponenten umschließen einen Innenraum. Auf den dem Innenraum zugewandten Seiten der Komponenten sind Verstärkungsstreben gebildet. Im unteren Abschnitt ist der Rahmen ohne die Vorderwand 1 gezeigt, sodass ein Nutzer Zugriff auf den Innenraum hat.

Auf der Vorderwand 1 ist ein Griff 5 gebildet. Der Griff 5 ist in einer Mulde angeordnet, die zentriert auf der Vorderwand 1 angeordnet ist.

In der ersten und zweiten Seitenwand 2, 3 sind Bohrungen 6, 7 zur Aufnahme von Schrauben gebildet. Hiermit kann das Kabelgehäuse an einem Industriesteckverbinder befestigt werden. Des Weiteren ist in der ersten Seitenwand 2 ein Durchbruch 8 gebildet. Dieser dient der Montage der ersten Seitenwand 2 an der Rückwand 4.

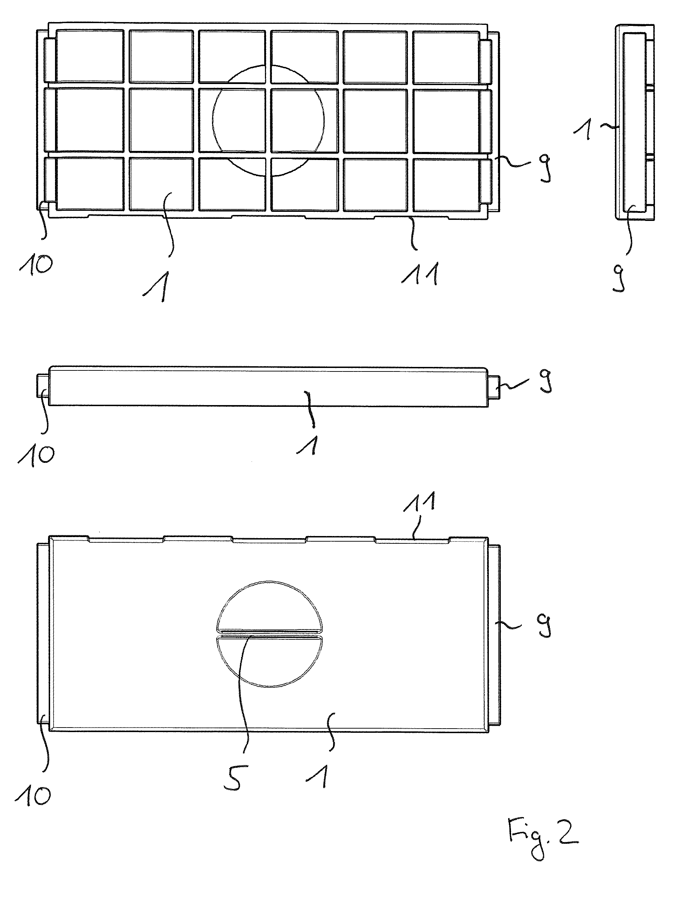

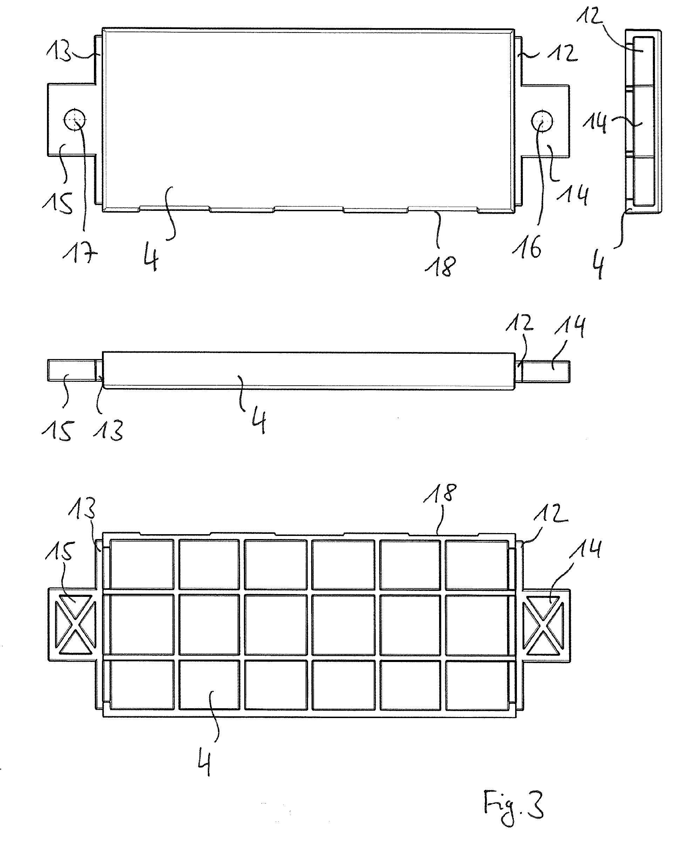

In Fig. 2 sind mehrere Ansichten der Vorderwand 2 dargestellt. An den Seiten der Vorderwand 2 sind Vorsprünge 9, 10 gebildet. Diese greifen im montierten Zustand in entsprechende Aufnahmen ein, die in der ersten und zweiten Seitenwand 2, 3 gebildet sind. An einer Seite der Vorderwand 1 sind Ausnehmungen 11 gebildet, die als Wärmeableitelemente wirken. Verschiedene Ansichten der Rückwand 4 sind in Fig. 3 gezeigt. Auf gegenüberliegenden Seiten der Rückwand 4 sind Vorsprünge 12, 13 mit Halteelementen 14, 15 gebildet. Die Halteelemente 14, 15 greifen in den Durchbruch 8 der ersten und zweiten Seitenwand 2, 3 ein. Auf einer dem Innenraum abgewandten Seite der Halteelemente 14, 15 sind Kugelaufnahmen 16, 17 gebildet. Diese nehmen jeweils einen Kugelvorsprung auf, der an der ersten bzw. zweiten Seitenwand 2, 3 gebildet ist. An der Rückwand 4 sind ebenfalls Ausnehmungen 18 zur Wärmeabfuhr gebildet.

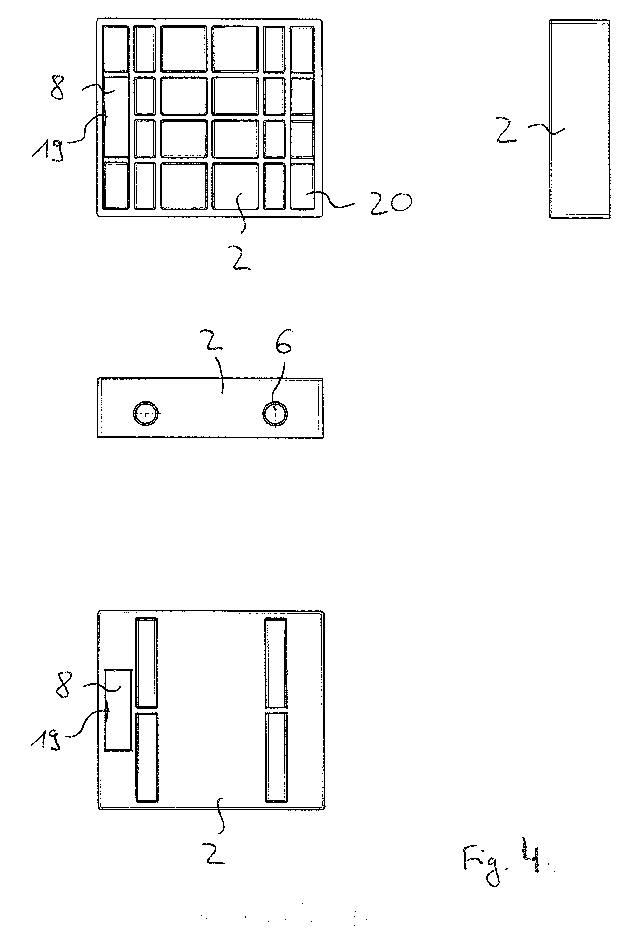

Fig. 4 zeigt mehrere Ansichten der ersten Seitenwand 2. In der ersten Seitenwand 2 ist ein Durchbruch 8 zur Aufnahme des Halteelements 14 gebildet. In dem Durchbruch ist ein Kugelvorsprung 19 gebildet, der im montierten Zustand in die Kugelaufnahme 16 eingreift. Des Weiteren weist die erste Seitenwand 2 eine vordere Aufnahme 20 auf, mit welcher im montierten Zustand der Vorsprung 9 der Vorderwand 1 in Eingriff steht. Für die zweite Seitenwand 3 gelten die Ausführungen analog.

Die Komponenten können mittels eines Spritzgussverfahrens aus einem Kunststoff hergestellt werden. Alternativ können die Komponenten aus einem Zinkdruckgussmaterial bestehen.

Die in der Beschreibung, den Ansprüchen und den Figuren offenbarten Merkmale können sowohl einzeln als auch in beliebiger Kombination miteinander für die Verwirklichung der Erfindung von Bedeutung sein.

## Patentansprüche

1. Kabelgehäuse zur Montage an einem Industriesteckverbinder, mit einem einen Innenraum umschließenden Rahmen, wobei der Innenraum ein oder mehrere aus dem Industriesteckverbinder herausragende Kabel aufnimmt, wobei der Rahmen eine Vorderwand (1) aufweist, die von dem Rahmen lösbar ist, derart, dass ein Zugriff zu dem Innenraum ermöglicht ist, und wobei auf einer dem Industriesteckverbinder zugewandten Seite des Rahmens ein Befestigungselement (6) zum Befestigen des Rahmens an dem Industriesteckverbinder gebildet ist.

2. Kabelgehäuse nach Anspruch 1, wobei der Rahmen eine erste Seitenwand (2), eine zweite Seitenwand (3) und eine Rückwand (4) aufweist.

3. Kabelgehäuse nach Anspruch 2, wobei an zwei gegenüberüberliegenden Seiten der Rückwand (4) jeweils ein Vorsprung (12, 13) mit einem auf dem Vorsprung angeordneten Halteelement (14, 15) gebildet ist, wobei der Vorsprung (12, 13) mit dem Halteelement (14, 15) in eine in der ersten und zweiten Seitenwand (2, 3) jeweils gebildeten hinteren Aufnahme (8) eingreift.

4. Kabelgehäuse nach Anspruch 3, wobei in der jeweiligen hinteren Aufnahme (8) der ersten und zweiten Seitenwand (2, 3) ein Kugelvorsprung (19) gebildet ist und auf dem Halteelement (14, 15) eine Kugelaufnahme (16) gebildet ist, sodass der Kugelvorsprung (19) und die Kugelaufnahme (16) im montierten Zustand miteinander in Eingriff stehen.

5. Kabelgehäuse nach Anspruch 3 oder 4, wobei der Vorsprung (12, 13) auf einer dem Innenraum abgewandten Seite jeweils zumindest abschnittsweise mit einer abgeschrägten Kante gebildet ist.

6. Kabelgehäuse nach einem der Ansprüche 2 bis 5, wobei die Vorderwand (1) zwischen der ersten und zweiten Seitenwand (2, 3) eingeklemmt ist.

7. Kabelgehäuse nach einem der vorangehenden Ansprüche, wobei an der Vorderwand (1) ein Griffelement (5) gebildet ist.

8. Kabelgehäuse nach einem der vorangehenden Ansprüche, wobei der Rahmen ein Kunststoffmaterial oder ein Zinkdruckgussmaterial enthält.

9. Kabelgehäuse nach einem der vorangehenden Ansprüche, wobei an einer dem Industriesteckverbinder abgewandten Seite des Rahmens Wärmeableitelemente (11, 18) gebildet sind.

10. Anordnung umfassend einen Industriesteckverbinder und ein hieran montiertes Kabelgehäuse nach einem der vorangehenden Ansprüche.
